# EUROPÄISCHE PATENTSCHRIFT

(11) **EP 3 120 114 B1**
(45) Veröffentlichungstag und Bekanntmachung des Hinweises auf die Patenterteilung: **11.04.2018**
(21) Anmeldenummer: 15709945.8
(22) Anmeldetag: 16.03.2015
(51) Int. Cl.: G01D 11/24, G01P 1/02, G01D 5/14, H03K 17/95

(54) **STABFÖRMIGER MAGNETFELDSENSOR**
ROD-SHAPED MAGNETIC FIELD SENSOR
CAPTEUR DE CHAMP MAGNETIQUE EN FORME DE TIGE

(30) Priorität: 21.03.2014 DE 102014205307
(43) Veröffentlichungstag der Anmeldung: 25.01.2017
(73) Patentinhaber: Continental Automotive GmbH, 30165 Hannover (DE)
(72) Erfinder: WAHLER, Torsten, 78073 Bad Dürrheim (DE); HUG, Klaus, 78727 Oberndorf (DE)
(86) Internationale Anmeldenummer: PCT/EP2015/055393
(87) Internationale Veröffentlichungsnummer: WO 2015/140089

(56) Entgegenhaltungen:
- DE-A1- 3 123 594
- DE-A1- 10 320 145
- DE-A1-102011 084 741
- DE-C2- 4 140 403
- DE-U1-202008 009 002

## Beschreibung

Die Erfindung bezieht sich auf einen stabförmigen Magnetfeldsensor mit einem ein Außengewinde aufweisenden Außengehäuse und mit einem eine Hallsonde und einen Permanentmagneten aufweisenden Sensorkopf.
Ein Magnetfeldsensor der vorgenannten Art ist zum Beispiel als sogenannter Geschwindigkeitsgeber für einen Fahrtenschreiber in einem Kraftfahrzeug, insbesondere Nutzfahrzeug, bekannt. Der Magnetfeldsensor wird in ein Getriebegehäuse eines Getriebes des Kraftfahrzeugs eingeschraubt und erfasst mittels seines Sensorkopfs eine Bewegung eines Getriebezahnrades des Getriebes. Für eine präzise Funktionsweise des Magnetfeldsensors ist eine exakte Positionierung des Sensorkopfs zu dem Getriebezahnrad erforderlich. Ferner erfordert eine dauerhaft zuverlässige Funktionsweise des Magnetfeldsensors einen Schutz insbesondere der elektronischen und elektrischen Bauelemente des Magnetfeldsensors vor aggressiven Umgebungseinflüssen, wie hohen Temperaturen und Schmierstoffen, in dem Getriebegehäuse. Diesem Schutz dient das Außengehäuse.
Einen bekannten Magnetfeldsensor der beschriebenen Art offenbart DE 41 40 403 C2 als Magnetfeldgeber mit einem topfförmigen Gehäuse. Das Gehäuse weist dabei ein hülsenförmiges Gebergehäuse auf, welches an einem ersten Gebergehäuseende mittels einer Kappe abgeschlossen und an einem dem ersten Gebergehäuseende gegenüberliegenden zweiten Gebergehäuseende mittels einer Bördelung mit einem Geberkontakte zum Anschluss des Magnetfeldgebers aufweisenden Steckersockel verbunden ist. An dem ersten Gebergehäuseende ist ein Sensorkopf in das Gebergehäuse eingeführt und durch eine Vergussmasse befestigt. Der Sensorkopf weist einen Hallgenerator und einen hülsenförmigen Permanentmagneten auf. Ein an dem Gebergehäuse ausgebildetes Gewinde dient einem Befestigen des Magnetfeldgebers an einem Getriebegehäuse eines Kraftfahrzeugs, und zwar unter Zwischenlage eines an dem Gebergehäuse unverlierbar gehalterten Ringes zwischen Magnetfeldgeber und Getriebegehäuse.

Für unterschiedliche Längenvarianten des bekannten Magnetsfeldsensors sind Gebergehäuse mit unterschiedlichen Gehäuselängen und gegebenenfalls Ringe unterschiedlicher Anzahl und/oder unterschiedlicher Dicke vorgegehen.

Aus DE 31 23 594 A1 ist ein Näherungsschalter mit einem Gehäuse aus Metall und einem Verschlussteil aus Kunststoff bekannt. Einen Näherungsschalter mit einer ein Außengewinde aufweisenden metallischen Außenhülle offenbart DE 10 2011 084 741 A1.

Ferner ist aus DE 20 2008 009 002 U1 ein Magnetfeldsensor mit einer elektrischen Baugruppe bekannt, wobei die elektrische Baugruppe mit Kunststoff umhüllt ist. Weiterhin offenbart DE 103 20 145 A1 eine magnetische Detektionsvorrichtung mit einem ersten Block mit einem magnetischen Detektionsteil und mit einem zweiten Block mit einem Magnetfelderzeugungsteil. Die magnetische Detektionseinrichtung weist ein den ersten Block und den zweiten Block bedeckendes Harz auf.

Aufgabe der Erfindung ist es, einen Magnetfeldsensor der eingangs genannten Art zu schaffen, der vereinfacht herstellbar ist und eine hohe Messgenauigkeit aufweist.

Diese Aufgabe wird erfingdungsgemäß dadurch gelöst, dass das Außengehäuse ein den Sensorkopf einbettendes Dunststoffspritzgussbauteil ist und eine das Außengewinde aufweisende, in das Kunststoffspritzgussbauteil eingespritzte Gewindehülse aufweist.

Vorteilhaft sind mit der Erfindung weder vorgefertigte Gebergehäuse mit unterschiedlichen Gehäuselängen noch Ringe erforderlich, um unterschiedliche Längenvarianten des Magnetfeldsensors herstellen zu können. Denn aufgrund der Ausbildung des Außengehäuses als Kunststoff spritzgussbauteil können bei der Erfindung in einfacher Weise unterschiedliche Längenvarianten des Magnetfeldsensors mit Hilfe einer Verwendung unterschiedlicher Spritzgießwerkzeugformen hergestellt werden. Grundsätzlich ist es auch vorstellbar, ein einziges Spritzgießwerkzeug für verschiedene Längenvarianten des Magnetfeldsensors zu verwenden, wobei je nach Längenvariante unterschiedliche Werkzeugeinsätze für das Spritzgießwerkzeug verwendet werden.

Von wesentlichem Vorteil ist bei der Erfindung, dass die Gewindehülse in das Außengehäuse eingespritzt ist. Dadurch kann für die Gewindehülse ein anderer Werkstoff als das Kunststoffspritzgussmaterial des Außengehäuses gewählt werden, welcher andere Werkstoff insbesondere eine höhere mechanische Festigkeit aufweisen kann als das Kunststoffspritzgussbauteil. Die Gewindehülse dient einem Einschrauben des Magnetfeldsensors in eine Gehäusewandung eines Gehäuses, insbesondere eines Getriebegehäuses. Vorzugsweise besteht die Gewindehülse aus Metall.

Ein weiterer Vorteil der Erfindung besteht darin, dass der Sensorkopf in das Außengehäuse eingebettet ist. Vorzugsweise ist der Sensorkopf vollständig in das Außengehäuse eingebettet. Damit ist der Sensorkopf durch das als Kunststoffspritzgussbauteil ausgebildete Außengehäuse vollständig nach außen hin abgeschlossen. Nach außen hin gegen Umgebungseinflüsse abzudichtende Übergangsbereiche zwischen verschiedenen Gehäusebauteilen, wie sie aus dem Stand der Technik bekannt sind, entfallen mit der Erfindung vorteilhaft. Außerdem besteht ein zuverlässiger Schutz gegen mechanische Belastung, insbesondere Stoß und Vibration, da insbesondere die empfindlichen elektronischen und elektrischen Bauelemente des Sensorkopfs vollständig von Kunststoffspritzgussmaterial des Außengehäuses umschlossen sind. Das Kunststoffspritzgussmaterial ist vorzugsweise ein Duroplast. Insbesondere kann das Kunststoffspritzgussmaterial ein Epoxid sein.

Zusätzliche vorteilhafte Weiterbildungen der Erfindung sind in den Unteransprüchen angegeben.

Ein einfacher Aufbau und eine erhöhte Stabilität des Magnetfeldsensors kann vorteilhaft dadurch erreicht werden, dass gemäß einer Weiterbildung der Erfindung die Hallsonde an einer sich parallel zu einer Sensorlängsachse des Magnetfeldsensors erstreckenden Leiterplatte angeordnet ist. Vorzugsweise ist die Hallsonde an einer ersten Stirnseite der Leiterplatte angeordnet.

Gemäß einer anderen vorteilhaften Weiterbildung der Erfindung weist der Sensorkopf eine die Hallsonde und den Permanentmagneten zueinander festlegende Positionierhülse auf. Die Positionierhülse positioniert somit die Hallsonde und den Permanentmagneten exakt zueinander, wodurch eine hohe Messgenauigkeit erreicht wird. Die Positionierhülse ist in das Außengehäuse eingebettet, so dass sie selbst fest und zuverlässig in dem Magnetfeldsensor angeordnet und gehalten ist.

Einer vorteilhaften Weiterbildung der Erfindung gemäß ist die Hallsonde an einer Leiterplatte angeordnet, und die Positionierhülse positioniert die Hallsonde und den Permanentmagneten zu der Leiterplatte. Auf diese Weise wird die Herstellbarkeit des Magnetfeldsensors weiter vereinfacht, da eine die Leiterplatte mit der Hallsonde und dem Permanentmagneten sowie der Positionierhülse aufweisende Sensorbaugruppe vollständig und positionsgenau vorgefertigt werden kann. Vorzugsweise ist die Leiterplatte eine sich parallel zu einer Sensorlängsachse des Magnetfeldsensors erstreckende Leiterplatte.

Gemäß einer vorteilhaften Weiterbildung der Erfindung ist die Positionierhülse als Korb ausgebildet. Die Positionierhülse ist somit korbförmig, wodurch ein direkter Zufluss von Kunststoffspritzgussmaterial beim Herstellen des Außengehäuses zu der Hallsonde und dem Permanentmagneten ermöglicht wird. Nach einem Aushärten des Kunststoffspritzgussmaterials, das heißt in einem fertig hergestellten Magnetfeldsensor, werden folglich sowohl die Positionierhülse als auch die Hallsonde und der Permanentmagnet fest und lagegesichert in dem Außengehäuse gehalten. Weiter vorteilhaft werden durch eine Ausbildung der Positionierhülse als Korb Lufteinschlüsse beim Spritzgießen des Außengehäuses des Magnetfeldsensors ergänzend vermieden.

Es ist beispielsweise denkbar, dass die Positionierhülse ein in axialer Richtung bezogen auf die Sensorlängsachse des Magnetfeldsensors angeformtes Werkzeugaufnahmeelement zur Positionierung in einem Spritzgießwerkzeug zur Herstellung des Außengehäuses des Magnetfeldsensors aufweist; ein solches Werkzeugaufnahmeelement könnte nach der Herstellung des Außengehäuses des Magnetfeldsensors entfernt, zum Beispiel abgetrennt, werden. Gemäß einer anderen vorteilhaften Weiterbildung der Erfindung weist jedoch die Positionierhülse an ihrer Außenseite ein Werkzeugeingriffselement auf. Die Außenseite der Positionierhülse ist eine der Hallsonde und dem Permanentmagneten sowie der ersten Stirnseite der Leiterplatte abgewandte Seite der Positionierhülse. Vorzugsweise ist die Außenseite, an welcher das Werkzeugeingriffselement angeordnet ist, eine bezogen auf die Sensorlängsachse des Magnetfeldsensors radial nach außen weisende Außenseite der Positionierhülse. Das Werkzeugeingriffselement der Positionierhülse bietet in einfacher Weise die Möglichkeit eines Eingriffs eines Einstellelements eines Spritzgießwerkzeugs, in welchem das Außengehäuse des Magnetfeldsensors spritzgegossen wird, beim Spritzgießen des Außengehäuses, wodurch die Positionierhülse und mit dieser der gesamte Sensorkopf des Magnetfeldsensors präzise in dem Spritzgießwerkzeug positioniert werden kann. Das Einstellelement des Spritzgießwerkzeugs greift in das Werkzeugeingriffselement der Positionierhülse ein und hält es in dem Spritzgießwerkzeug genau in einer vorgesehenen Position. Damit kann äußerst präzise eine exakte Lage des Sensorkopfes gegenüber dem Außengehäuse erreicht werden. Vorzugsweise ist das Werkzeugeingriffselement in einem vorderen Bereich der Positionierhülse, das heißt in einem Bereich der Positionierhülse, der einem ersten Ende des Magnetfeldsensors zugewandt ist, angeordnet. Das erste Ende des Magnetfeldsensors ist dasjenige Ende des Magnetfeldsensors, dem auch der Sensorkopf insgesamt zugewandt ist.

Vorteilhaft kann die Bandbreite der möglichen Längenvarianten des Magnetfeldsensors besonders groß sein, wenn gemäß einer anderen Weiterbildung der Erfindung die Positionierhülse eine zylindrische Außenform und die Gewindehülse eine mit der Außenform der Positionierhülse korrespondierende, zylindrische Innenform besitzt, wobei die Außenform der Positionierhülse kleiner ist als die Innenform der Gewindehülse. Dadurch ist die Positionierhülse in die Gewindehülse einführbar, so dass auch besonders kurze und kompakte Magnetfeldsensoren ohne Änderung der Bauteile Positionierhülse und Gewindehülse herstellbar sind.

Die Positionierhülse und die Gewindehülse sind vereinfacht herstellbar und gut montierbar, wenn entsprechend einer vorteilhaften Weiterbildung der Erfindung die Positionierhülse eine kreiszylindrische Außenform und die Gewindehülse eine kreiszylindrische Innenform besitzt, wobei der größte Außendurchmesser der Außenform der Positionierhülse kleiner ist als der kleinste Innendurchmesser der Innenform der Gewindehülse.

Von Vorteil für eine hohe Stabilität und erleichterte Herstellbarkeit des Magnetfeldsensors ist es, wenn gemäß einer anderen Weiterbildung der Erfindung die Positionierhülse und die Gewindehülse eine Passung, vorzugsweise Spielpassung, bilden. Vorzugsweise bilden eine Außenform der Positionierhülse und eine Innenform der Gewindehülse die Passung, insbesondere Spielpassung. Die Passung wird somit gebildet, wenn die Positionierhülse zumindest teilweise in die Gewindehülse vorzugsweise eingeschoben ist.

Gemäß einer anderen vorteilhaften Weiterbildung der Erfindung weist die Gewindehülse eine zylindrische, insbesondere kreiszylindrische, Innenform mit einer Innenumfangsnut auf. Die Innenumfangsnut ist eine Nut am Innenumfang der Gewindehülse. Die Innenumfangsnut führt zu einem vorteilhaften Hintergreifen und somit besonders sicherem Halten der Gewindehülse durch das Kunststoffspritzgussmaterial des Außengehäuses, wenn die Positionierhülse nicht in die Gewindehülse eingeschoben ist, und außerdem zu der Möglichkeit eines guten Einfließens von Kunststoffspritzgussmaterial und Verfüllen eines Raumes zwischen Positionierhülse und Gewindehülse, wenn die Positionierhülse in die Gewindehülse zumindest teilweise eingeschoben ist.

Vorteilhaft weist gemäß einer anderen Weiterbildung der Erfindung die Gewindehülse einen Axialdichtbund des Magnetfeldsensors auf. Der Axialdichtbund springt gegenüber dem Außengewinde radial vor. Wenn der Magnetfelsensor in die Gehäusewandung eines Gehäuses, insbesondere Getriebegehäuses, eingeschraubt ist, liegt der Axialdichtbund an der Gehäusewandung an. Der Axialdichtbund kann dabei vorteilhaft zum einen als Anschlag für das Einschrauben des Magnetfeldsensors in das Gehäuse und zum anderen als Abdichtung für das Gehäuse dienen.

Ein besonders fester und zuverlässiger Halt der Gewindehülse in den Außengehäuse wird gemäß einer anderen vorteilhaften Weiterbildung der Erfindung dadurch erreicht, dass die Gewindehülse an einem ersten Hülsenendbereich der Gewindehülse das Außengewinde und an einem dem ersten Hülsenendbereich abgewandten zweiten Hülsenendbereich der Gewindehülse eine in das Kunststoffspritzgussbauteil eingespritzte Verzahnungsstruktur aufweist. Damit dient der erste Hülsenendbereich der Gewindehülse einem Einschrauben des Magnetfeldsensors in ein Gehäuse, insbesondere Getriebegehäuse, und der an dem anderen, dem zweiten Ende der Gewindehülse angeordnete zweite Hülsenendbereich der Gewindehülse dient einer sicheren und dauerhaltbaren Einbindung der Gewindehülse in das Außengehäuse des Magnetfeldsensors. Man kann sich zum Beispiel vorstellen, dass die Verzahnungsstruktur in radialer Richtung der Gewindehülse angeordnet ist. Für eine verbesserte Herstellbarkeit des Magnetfeldsensors, insbesondere des Außengehäuses des Magnetfeldsensors, ist die Verzahnungsstruktur vorzugsweise jedoch in axialer Richtung der Gewindehülse angeordnet.

Es ist beispielsweise denkbar, dass der Axialdichtbund am zweiten Ende der Gewindehülse angeordnet ist. Hingegen ist gemäß einer vorteilhaften Weiterbildung der Erfindung der Axialdichtbund des Magnetfeldsensors in Axialrichtung der Gewindehülse zwischen dem Außengewinde und der Verzahnungsstruktur der Gewindehülse angeordnet. Dadurch kann vorteilhaft eine vereinfachte Herstellbarkeit der Gewindehülse und des Außengehäuses erreicht werden. Die Axialrichtung der Gewindehülse entspricht der Axialrichtung des Magnetfeldsensors.

Für eine weiter vereinfachte Herstellbarkeit des Magnetfeldsensors sowie eine leichte und zuverlässige Einschraubbarkeit des Magnetfeldsensors in ein Gehäuse ist gemäß einer anderen vorteilhaften Weiterbildung der Erfindung ein das Außengewinde aufweisender erster Hülsenendbereich der Gewindehülse dem Sensorkopf zugewandt.

Für eine einfache Verbindbarkeit des Magnetfeldsensors mit einer Auswerteeinheit, insbesondere zum Beispiel mit einer als Fahrtenschreiber eines Kraftfahrzeugs ausgebildeten Auswerteeinheit, ist gemäß einer anderen vorteilhaften Weiterbildung der Erfindung an einem dem an einem ersten Ende des Magnetfeldsensors angeordneten Sensorkopf gegenüberliegenden zweiten Ende des Magnetfeldsensors ein mit einer Leiterplatte elektrisch kontaktierter Steckersockel angeordnet. Die Leiterplatte ist vorzugsweise diejenige Leiterplatte, an welcher die Hallsonde angeordnet ist.

Gemäß einer anderen vorteilhaften Weiterbildung der Erfindung weist eine sich parallel zu der Sensorlängsachse des Magnetfeldsensors erstreckende Leiterplatte eine Verjüngung auf, und die Gewindehülse ist im Bereich der Verjüngung der Leiterplatte angeordnet, so dass die Leiterplatte von der Gewindehülse beabstandet ist. Die Leiterplatte weist in radialer Richtung bezogen auf die Sensorlängsachse einen Abstand von der Gewindehülse auf. Somit weist die Leiterplatte einen Abstand von einer Innenwandung der Gewindehülse auf. Die Leiterplatte liegt folglich nicht flächig oder linienförmig an der Innenwandung der Gewindehülse an, sondern zwischen Leiterplatte und Gewindehülse besteht ein Zwischenraum, in welchen Zwischenraum Kunststoffspritzgussmaterial beim Herstellen des Außengehäuses gut einfließen kann. Für eine präzise Positionierung der Gewindehülse gegenüber der Leiterplatte ist es von Vorteil, wenn die Leiterplatte an ihren beiden Außenkanten gegenüberliegend jeweils eine Noppe zum Abstützen der Gewindehülse aufweist. Vorzugsweise ist die Leiterplatte diejenige Leiterplatte, an welcher die Hallsonde angeordnet ist.

Ausführungsbeispiele der Erfindung sind in der Zeichnung schematisiert und skizzenhaft dargestellt und werden im Folgenden näher beschrieben. Es zeigen
- Figur 1: einen Magnetfeldsensor mit einem Sensorkopf in einem ersten Längsschnitt entlang einer Sensorlängsachse,
- Figur 2: den Magnetfeldsensor nach Figur 1 in einem zweiten Längsschnitt entlang der Sensorlängsachse,
- Figur 3: den Sensorkopf des Magnetfeldsensors nach Figur 1 in einem weiteren Längsschnitt,
- Figur 4: eine Gewindehülse des Magnetfeldsensors nach Figur 1 in einem Längsschnitt,
- Figur 5: den Sensorkopf des Magnetfeldsensors nach Figur 1 in einer perspektivischen Ansicht,
- Figur 6: einen zweiten Magnetfeldsensor mit einem Sensorkopf in einem Längsschnitt entlang einer Sensorlängsachse,
- Figur 7: einen dritten Magnetfeldsensor mit einem Sensorkopf in einem Längsschnitt entlang einer Sensorlängsachse und
- Figur 8: einen vierten Magnetfeldsensor mit einem Sensorkopf in einem Längsschnitt entlang einer Sensorlängsachse.

Sich jeweils entsprechende Elemente sind in allen Figuren mit gleichen Bezugszeichen versehen.

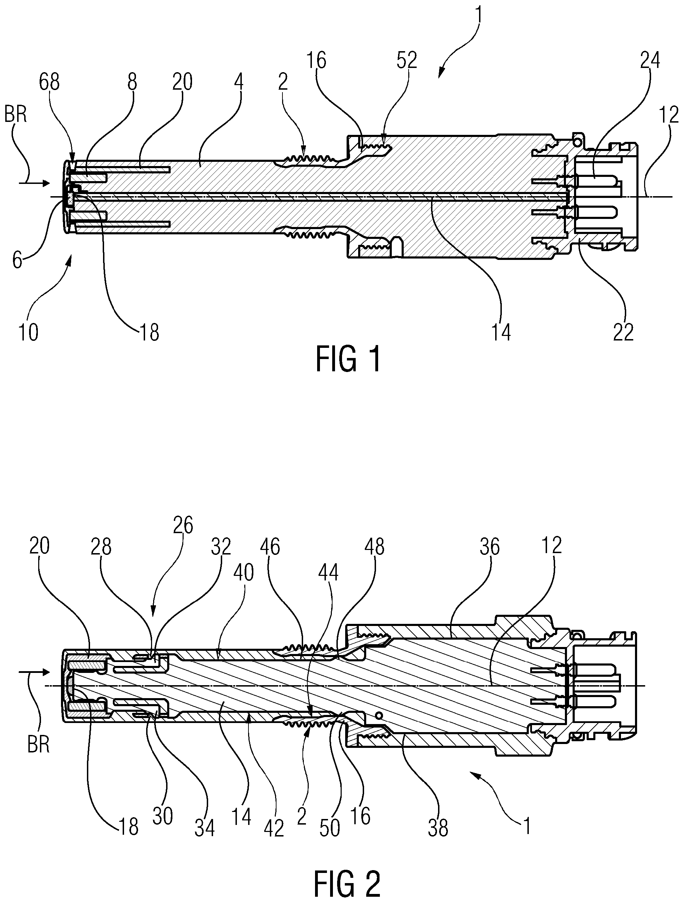

Figur 1 zeigt einen stabförmigen Magnetfeldsensor 1 mit einem ein Außengewinde 2 aufweisenden Außengehäuse 4 und mit einem eine Hallsonde 6 und einen Permanentmagneten 8 aufweisenden Sensorkopf 10 in einem Längsschnitt. Die Hallsonde 6 ist an einer sich parallel zu einer Sensorlängsachse 12 des Magnetfeldsensors 1 erstreckenden Leiterplatte 14 angeordnet. In diesem Ausführungsbeispiel verläuft die Sensorlängsachse 12 durch die Leiterplatte 14, die Mittelachse der Leiterplatte 14 fällt mit der Sensorlängsachse 12 zusammen.

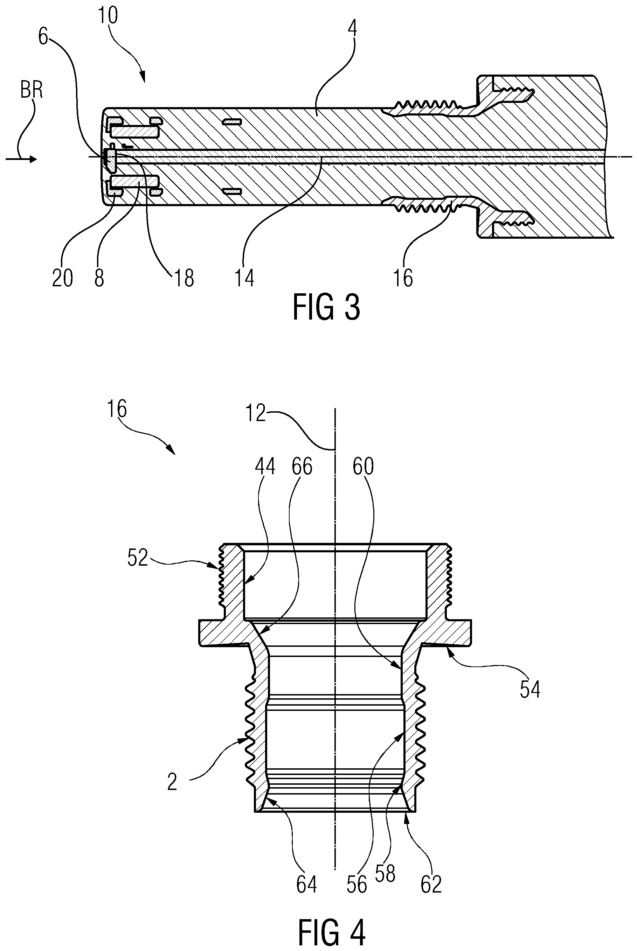

Das Außengehäuse 4 ist ein den Sensorkopf 10 einbettendes Kunststoffspritzgussbauteil, und das Außengehäuse 4 weist eine das Außengewinde 2 aufweisende, in das Kunststoffspritzgussbauteil eingespritzte Gewindehülse 16 auf. Die Gewindehülse 16 dient einem Einschrauben des Magnetfeldsensors 1 in zum Beispiel ein Getriebegehäuse eines Kraftfahrzeugs. Aus Figur 3, die den Sensorkopf 10 in einem gegenüber der Darstellung in Figur 1 um 45° bezogen auf eine durch einen Pfeil BR symbolisierte Blickrichtung gedrehten Längsschnitt zeigt, wird deutlich, dass der Sensorkopf 10 insgesamt vollständig in das Außengehäuse 4 eingebettet ist.

Der Kunststoff des Kunststoffspritzgussbauteils ist in diesem und den folgenden Ausführungsbeispielen ein Duroplast. Die Gewindehülse 16 besteht in diesem und den folgenden Ausführungsbeispielen aus einem Metall.

Die Hallsonde 6 ist an einer ersten Stirnseite 18 der Leiterplatte 14 angeordnet. Der Sensorkopf 10 weist eine die Hallsonde 6 und den Permanentmagneten 8, der als Ringmagnet ausgebildet ist, zueinander festlegende Positionierhülse 20 auf. Weiterhin positioniert die Positionierhülse 20 die Hallsonde 6 und den Permanentmagneten 8 zu der Leiterplatte 14.

Die Positionierhülse 20 ist als Korb ausgebildet, das heißt die Positionierhülse 20 ist korbförmig. Aufgrund der korbförmigen Positionierhülse 20 steht sowohl die Hallsonde 6 als auch der Permanentmagnet 8 in unmittelbarem Kontakt mit dem Außengehäuse 4. Nicht nur der Sensorkopf 10 insgesamt ist in das Außengehäuse 4 eingebettet, sondern auch die in direktem Kontakt mit dem Außengehäuse 4 stehenden Bauteile Positionierhülse 20, Hallsonde 6 und Permanentmagnet 8.

An einem dem an einem ersten Ende des Magnetfeldsensors 1 angeordneten Sensorkopf 10 gegenüberliegenden zweiten Ende des Magnetfeldsensors 1 befindet sich ein Steckersockel 22 mit Anschlusskontakten 24 zur Verbindung des Magnetfeldsensors 1 mit zum Beispiel einem Fahrtenschreiber des Kraftfahrzeugs.

Im Inneren des Magnetfeldsensors 1 sind die Anschlusskontakte 24 mit der Leiterplatte 14 elektrisch kontaktiert. Der Steckersockel 22 ist in das Außengehäuse 4 eingespritzt. Zwischen dem Steckersockel 22 und dem Sensorkopf 10 befindet sich in dem Magnetfeldsensor 1 die in das Außengehäuse 4 eingespritzte Gewindehülse 16.

Wie aus Figur 2, die den Magnetfeldsensor 1 in einem gegenüber der Darstellung in Figur 1 um 90° bezogen auf die durch einen Pfeil BR symbolisierte Blickrichtung gedrehten Längsschnitt zeigt, ersichtlich ist, ist die Positionierhülse 20 die erste Stirnseite 18 der Leiterplatte 14 übergreifend an der Leiterplatte 14 in axialer Richtung des Magnetfeldsensors 1 verschiebegesichert angeordnet. Dazu sind hier die Positionierhülse 20 und die Leiterplatte 14 mittels einer Rasteinrichtung 26 miteinander verbunden. Die Rasteinrichtung 26 weist zwei Hülsenausnehmungen 28, 30 in der Positionierhülse 20 und jeweils einen in jeweils eine der Hülsenausnehmungen 28, 30 eingreifenden Schnapphaken 32, 34 der Leiterplatte 14 auf.

Die sich parallel zu der Sensorlängsachse 12 des Magnetfeldsensors 1 erstreckende Leiterplatte 14 weist an ihren beiden gegenüberliegenden Längskanten 36, 38 jeweils eine Verjüngung 40, 42 auf, wobei die Gewindehülse 16 im Bereich dieser Verjüngungen 40, 42 angeordnet ist. Dadurch weist die Leiterplatte 14 einen Abstand zu einer Innenwandung 44 der Gewindehülse 16 auf.

Die Leiterplatte 14 liegt nicht flächig oder linienförmig an der Innenwandung 44 der Gewindehülse 16 an, sondern zwischen Leiterplatte 14 und Gewindehülse 16 besteht ein Zwischenraum 46, in welchen Zwischenraum 46 Kunststoffspritzgussmaterial beim Herstellen des Außengehäuses 4 gut einfließen kann. An ihren beiden Längskanten 36, 38 weist die Leiterplatte 14 gegenüberliegend jeweils eine Noppe 48, 50 im Bereich der Gewindehülse 16 auf, wobei die Noppen 48, 50 die Gewindehülse 16 an deren Innenwandung 44 abstützen. Die Noppen 48, 50 stützen die Gewindehülse 16 hier an einer zweiten ringförmigen Positionierfläche 60 (siehe Figur 4) der Innenwandung 44 der Gewindehülse 16 ab.

In einer Einzeldarstellung zeigt Figur 4 die Gewindehülse 16 in einem Längsschnitt. Die Gewindehülse 16 weist an einem ersten Hülsenendbereich der Gewindehülse 16, der dem Sensorkopf 10 (siehe Figur 1) zugewandt ist, das Außengewinde 2 auf. An einem dem ersten Hülsenendbereich abgewandten zweiten Hülsenendbereich der Gewindehülse 16, der dem Steckersockel 22 zugewandt ist, weist die Gewindehülse 16 eine in das Außengehäuse 4, das ein Kunststoffspritzgussbauteil ist, eingespritzte Verzahnungsstruktur 52 auf.

In Axialrichtung der Gewindehülse 16 ist zwischen dem Außengewinde 2 und der Verzahnungsstruktur 52 ein Axialdichtbund 54 des Magnetfeldsensors 1 angeordnet. Der Axialdichtbund 54 springt gegenüber dem Außengewinde 2 und der Sensorlängsachse 12 radial nach außen vor. Weiterhin weist die Gewindehülse 16 eine kreiszylindrische Innenform mit einer Innenumfangsnut 56 auf. Die Innenumfangsnut 56 ist am Innenumfang der Gewindehülse 16 angeordnet und in der Innenwandung 44 der Gewindehülse 16 ausgebildet. Angeordnet ist die Innenumfangsnut 56 hier im Bereich des Außengewindes 2 der Gewindehülse 16.

Außerdem weist die Innenwandung 44 der Gewindehülse 16 eine erste ringförmige Positionierfläche 58 und eine zweite ringförmige Positionierfläche 60 auf. Die Innenumfangsnut 56 ist in Axialrichtung der Gewindehülse 16 zwischen der ersten Positionierfläche 58 und der zweiten Positionierfläche 60 angeordnet.

Der erste Hülsenendbereich der Gewindehülse 16 weist ein erstes Ende 62 der Gewindehülse 16 mit einem ersten Übergangsbereich 64 an der Innenwandung 44 der Gewindehülse 16 auf. Ein zweiter Übergangsbereich 66 an der Innenwandung 44 der Gewindehülse 16 ist in Axialrichtung der Gewindehülse 16 zwischen dem Außengewinde 2 und der Verzahnungsstruktur 52 im Bereich des Axialdichtbundes 54 angeordnet. Der erste Übergangsbereich 64 und der zweite Übergangsbereich 66 sind für ein leichtes Einfließen des Kunststoffspritzgussmaterials in die Gewindehülse 16 ausgebildet.

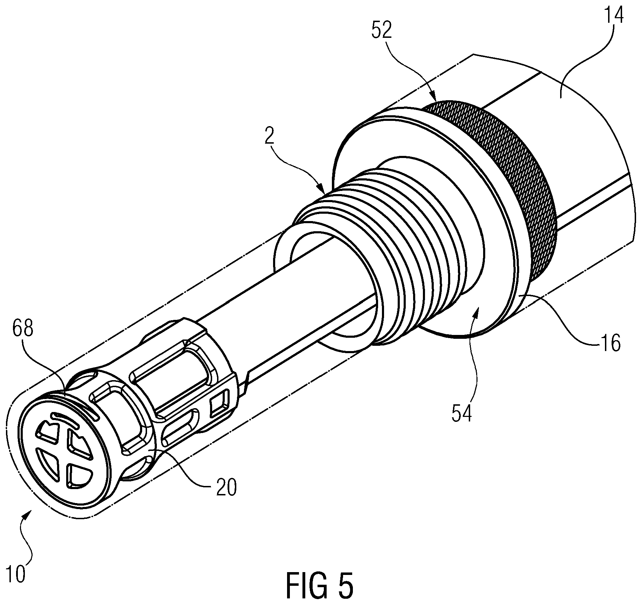

Zur weiteren Verdeutlichung des Aufbaus des Magnetfeldsensors 1 zeigt Figur 5 den Sensorkopf 10 und die Gewindehülse 16 des Magnetfeldsensors 1 nach Figur 1 in einer perspektivischen Ansicht, wobei das Außengehäuse der Übersichtlichkeit halber weggelassen und lediglich durch eine strichdoppelpunktierte Linie angedeutet ist. Es ist zu erkennen, dass die Positionierhülse 20 an ihrer Außenseite ein Werkzeugeingriffselement 68 aufweist. Das Werkzeugeingriffselement ist in einem vorderen Bereich der Positionierhülse 20 angeordnet. Weiterhin ist zu erkennen, dass die Positionierhülse 20 eine kreiszylindrische Außenform und die Gewindehülse 16 eine kreiszylindrische Innenform besitzt, wobei der größte Außendurchmesser der Außenform der Positionierhülse 20 kleiner ist als der kleinste Innendurchmesser der Innenform der Gewindehülse 16.

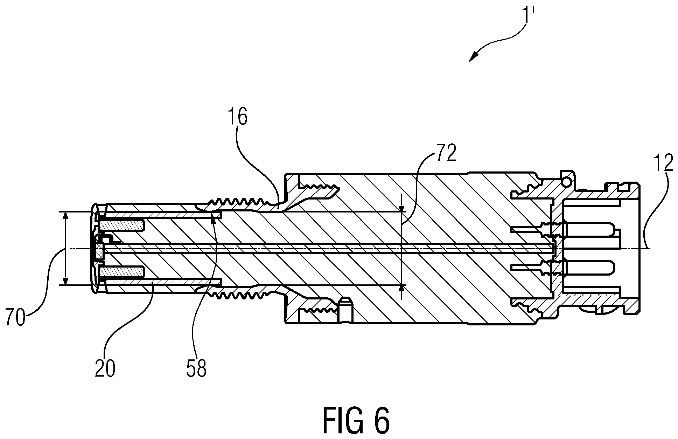

Dadurch können, ohne dass Änderungen an der Positionierhülse 20 und/oder an der Gewindehülse 16 vorgenommen werden müssten, beispielhaft in Figuren 6 bis 8 gezeigte Varianten des Magnetfeldsensors bei dessen Herstellung gebildet werden. Bei den in Figuren 6 bis 8 gezeigten Varianten des Magnetfeldsensors ist jeweils die Positionierhülse 20 zumindest teilweise in die Gewindehülse 16 eingetaucht.

Figur 6 zeigt einen zweiten Magnetfeldsensor 1' mit einer gegenüber dem Magnetfeldsensor 1 nach Figur 1 verkürzten Gehäuselänge. Dabei ragt die Positionierhülse 20 in die Gewindehülse 16 bis zu der ersten Positionierfläche 58 (siehe auch Figur 4) und etwas darüber hinaus hinein.

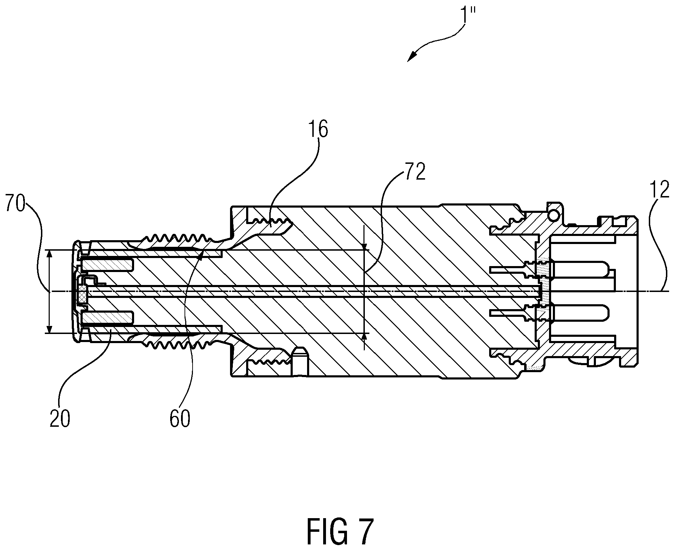

Figur 7 zeigt einen dritten Magnetfeldsensor 1" mit einer gegenüber dem Magnetfeldsensor 1 nach Figur 1 weiter verkürzten Gehäuselänge. Dabei ragt die Positionierhülse 20 in die Gewindehülse 16 bis zu der zweiten Positionierfläche 60 (siehe auch Figur 4) hinein.

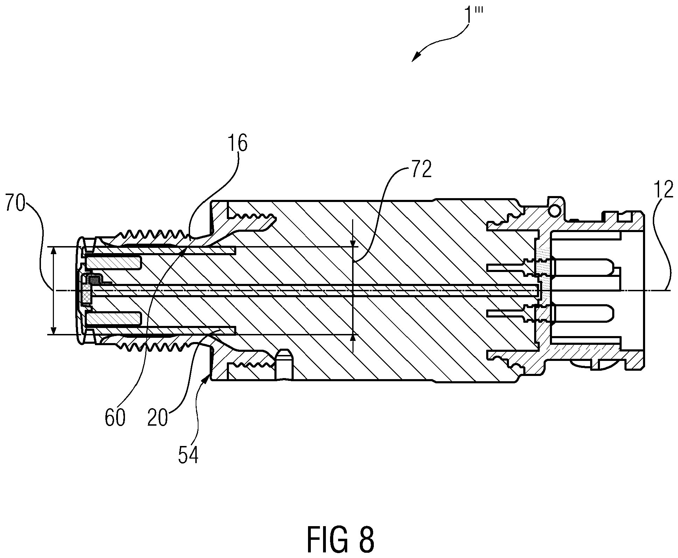

Figur 8 zeigt einen vierten Magnetfeldsensor 1'" mit einer gegenüber dem Magnetfeldsensor 1 nach Figur 1 noch weiter verkürzten Gehäuselänge. Dabei ragt die Positionierhülse 20 über die zweite Positionierfläche 60 (siehe auch Figur 4) hinaus bis zu dem Bereich des Axialbundes 54 in die Gewindehülse 16 hinein.

Es ist in den Figuren 6 bis 8 zu erkennen, dass die Positionierhülse 20 und die Gewindehülse 16 eine Passung bilden. Die Positionierhülse 20 besitzt eine zylindrische Außenform, und die Gewindehülse 16 besitzt eine mit der Außenform der Positionierhülse 20 korrespondierende, zylindrische Innenform, wobei die Außenform der Positionierhülse 20 kleiner ist als die Innenform der Gewindehülse. Dabei besitzt die Positionierhülse 20 eine kreiszylindrische Außenform und die Gewindehülse 16 eine kreiszylindrische Innenform, wobei der größte Außendurchmesser 70 der Außenform der Positionierhülse 20 kleiner ist als der kleinste Innendurchmesser 72 der Gewindehülse 16. Aufgrund der von der Gewindehülse 16 und der Positionierhülse 20 gebildeten Passung wird sowohl die Stabilität des jeweiligen Magnetfeldsensors 1', 1", 1'" erhöht als auch eine präzise Positionierung von Gewindehülse 16 und Positionierhülse 20 zueinander gewährleistet.

## Patentansprüche

1. Stabförmiger Magnetfeldsensor mit einem ein Außengewinde aufweisenden Außengehäuse und mit einem eine Hallsonde und einen Permanentmagneten aufweisenden Sensorkopf,
**dadurch gekennzeichnet, dass** das Außengehäuse (4) ein den Sensorkopf (10) einbettendes Kunststoffspritzgussbauteil ist und eine das Außengewinde (2) aufweisende, in das Kunststoffspritzgussbauteil eingespritzte Gewindehülse (16) aufweist.

2. Magnetfeldsensor nach Anspruch 1, **dadurch gekennzeichnet, dass** die Hallsonde (6) an einer sich parallel zu einer Sensorlängsachse (12) des Magnetfeldsensors (1) erstreckenden Leiterplatte (14) angeordnet ist.

3. Magnetfeldsensor nach Anspruch 1 oder 2, **dadurch gekennzeichnet, dass** der Sensorkopf (10) eine die Hallsonde (6) und den Permanentmagneten (8) zueinander festlegende Positionierhülse (20) aufweist.

4. Magnetfeldsensor nach Anspruch 3, **dadurch gekennzeichnet, dass** die Hallsonde (6) an einer Leiterplatte (14) angeordnet ist und dass die Positionierhülse (20) die Hallsonde (6) und den Permanentmagneten (8) zu der Leiterplatte (14) positioniert.

5. Magnetfeldsensor nach Anspruch 3 oder 4, **dadurch gekennzeichnet, dass** die Positionierhülse (20) als Korb ausgebildet ist.

6. Magnetfeldsensor nach einem der Ansprüche 3 bis 5,
**dadurch gekennzeichnet, dass** die Positionierhülse (20) an ihrer Außenseite ein Werkzeugeingriffselement (68) aufweist.

7. Magnetfeldsensor nach einem der Ansprüche 3 bis 6,
**dadurch gekennzeichnet, dass** die Positionierhülse (20) eine zylindrische Außenform und die Gewindehülse (16) eine mit der Außenform der Positionierhülse (20) korrespondierende, zylindrische Innenform besitzt, wobei die Außenform der Positionierhülse (20) kleiner ist als die Innenform der Gewindehülse (16).

8. Magnetfeldsensor nach Anspruch 7, **dadurch gekennzeichnet, dass** die Positionierhülse (20) eine kreiszylindrische Außenform und die Gewindehülse (16) eine kreiszylindrische Innenform besitzt, wobei der größte Außendurchmesser (70) der Außenform der Positionierhülse (20) kleiner ist als der kleinste Innendurchmesser (72) der Innenform der Gewindehülse (16).

9. Magnetfeldsensor nach einem der Ansprüche 3 bis 8,
**dadurch gekennzeichnet, dass** die Positionierhülse (20) und die Gewindehülse (16) eine Passung bilden.

10. Magnetfeldsensor nach einem der vorhergehenden Ansprüche,
**dadurch gekennzeichnet, dass** die Gewindehülse (16) eine zylindrische Innenform mit einer Innenumfangsnut (56) aufweist.

11. Magnetfeldsensor nach einem der vorhergehenden Ansprüche,
**dadurch gekennzeichnet, dass** die Gewindehülse (16) einen Axialdichtbund (54) des Magnetfeldsensors (1) aufweist.

12. Magnetfeldsensor nach einem der vorhergehenden Ansprüche,
**dadurch gekennzeichnet, dass** die Gewindehülse (16) an einem ersten Hülsenendbereich der Gewindehülse (16) das Außengewinde (2) und an einem dem ersten Hülsenendbereich abgewandten zweiten Hülsenendbereich der Gewindehülse (16) eine in das Kunststoffspritzgussbauteil eingespritzte Verzahnungsstruktur (52) aufweist.

13. Magnetfeldsensor nach den Ansprüchen 11 und 12, **dadurch gekennzeichnet, dass** der Axialdichtbund (54) des Magnetfeldsensors (1) in Axialrichtung der Gewindehülse (16) zwischen dem Außengewinde (2) und der Verzahnungsstruktur (52) der Gewindehülse (16) angeordnet ist.

14. Magnetfeldsensor nach einem der vorhergehenden Ansprüche,
**dadurch gekennzeichnet, dass** ein das Außengewinde (2) aufweisender erster Hülsenendbereich der Gewindehülse (16) dem Sensorkopf (10) zugewandt ist.

15. Magnetfeldsensor nach einem der vorhergehenden Ansprüche,
**dadurch gekennzeichnet, dass** an einem dem an einem ersten Ende des Magnetfeldsensors (1) angeordneten Sensorkopf (10) gegenüberliegenden zweiten Ende des Magnetfeldsensors (1) ein mit einer Leiterplatte (14) elektrisch kontaktierter Steckersockel (22) angeordnet ist.

16. Magnetfeldsensor nach einem der vorhergehenden Ansprüche,
**dadurch gekennzeichnet, dass** eine sich parallel zu der Sensorlängsachse (12) des Magnetfeldsensors (1) erstreckende Leiterplatte (14) eine Verjüngung (40, 42) aufweist und dass die Gewindehülse (16) im Bereich der Verjüngung (40, 42) der Leiterplatte (14) angeordnet ist, so dass die Leiterplatte (14) von der Gewindehülse (16) beabstandet ist.

## Claims

1. Rod-shaped magnetic field sensor with an external housing having an external thread and with a sensor head having a Hall probe and a permanent magnet,
**characterized in that** the external housing (4) is a plastic injection-moulded component that embeds the sensor head (10) and has a threaded sleeve (16) injected into the plastic injection-moulded component, said threaded sleeve having the external thread (2).

2. Magnetic field sensor according to Claim 1, **characterized in that** the Hall probe (6) is arranged on a printed circuit board (14) that extends parallel to a sensor longitudinal axis (12) of the magnetic field sensor (1).

3. Magnetic field sensor according to Claim 1 or 2,
**characterized in that** the sensor head (10) has a positioning sleeve (20) that fixes the Hall probe (6) and the permanent magnet (8) in relation to one another.

4. Magnetic field sensor according to Claim 3, **characterized in that** the Hall probe (6) is arranged on a printed circuit board (14) and **in that** the positioning sleeve (20) positions the Hall probe (6) and the permanent magnet (8) relative to the printed circuit board (14).

5. Magnetic field sensor according to Claim 3 or 4,
**characterized in that** the positioning sleeve (20) is designed as a basket.

6. Magnetic field sensor according to one of Claims 3 to 5,
**characterized in that** the positioning sleeve (20) has a tool engaging element (68) on the external side of said positioning sleeve.

7. Magnetic field sensor according to one of Claims 3 to 6,
**characterized in that** the positioning sleeve (20) has a cylindrical external shape and the threaded sleeve (16) has a cylindrical internal shape that corresponds to the external shape of the positioning sleeve (20), wherein the external shape of the positioning sleeve (20) is smaller than the internal shape of the threaded sleeve (16).

8. Magnetic field sensor according to Claim 7, **characterized in that** the positioning sleeve (20) has a circular cylindrical external shape and the threaded sleeve (16) has a circular cylindrical internal shape, wherein the largest external diameter (70) of the external shape of the positioning sleeve (20) is smaller than the smallest internal diameter (72) of the internal shape of the threaded sleeve (16).

9. Magnetic field sensor according to one of Claims 3 to 8,
**characterized in that** the positioning sleeve (20) and the threaded sleeve (16) form a fit.

10. Magnetic field sensor according to one of the preceding claims, **characterized in that** the threaded sleeve (16) has a cylindrical internal shape with an internal circumferential groove (56).

11. Magnetic field sensor according to one of the preceding claims, **characterized in that** the threaded sleeve (16) has an axial sealing collar (54) of the magnetic field sensor (1).

12. Magnetic field sensor according to one of the preceding claims, **characterized in that** the threaded sleeve (16) has, at a first sleeve end region of the threaded sleeve (16), the external thread (2) and, at a second sleeve end region of the threaded sleeve (16) facing away from the first sleeve end region, a toothing structure (52) that is injected into the plastic injection-moulded component.

13. Magnetic field sensor according to Claims 11 and 12,
**characterized in that** the axial sealing collar (54) of the magnetic field sensor (1) is arranged in the axial direction of the threaded sleeve (16) between the external thread (2) and the toothing structure (52) of the threaded sleeve (16).

14. Magnetic field sensor according to one of the preceding claims, **characterized in that** a first sleeve end region of the threaded sleeve (16) faces the sensor head (10), said first sleeve end region having the external thread (2).

15. Magnetic field sensor according to one of the preceding claims, **characterized in that** a female connector (22) that is electrically contact-connected to a printed circuit board (14) is arranged at a second end of the magnetic field sensor (1), said second end being opposite the sensor head (10) arranged at a first end of the magnetic field sensor (1).

16. Magnetic field sensor according to one of the preceding claims, **characterized in that** a printed circuit board (14) that extends parallel to the sensor longitudinal axis (12) of the magnetic field sensor (1) has a narrowed portion (40, 42) and **in that** the threaded sleeve (16) is arranged in the region of the narrowed portion (40, 42) of the printed circuit board (14) such that the printed circuit board (14) is spaced apart from the threaded sleeve (16).

## Revendications

1. Capteur de champ magnétique en forme de tige comportant un boîtier extérieur muni d'un filetage extérieur et comportant une tête de capteur munie d'une sonde à effet Hall et d'un aimant permanent, **caractérisé en ce que** le boîtier extérieur (4) est un composant moulé par injection en matière plastique qui intègre la tête de capteur (10) et comporte un manchon fileté (16) muni du filetage mâle (2) et encapsulé dans le composant moulé par injection en matière plastique.

2. Capteur de champ magnétique selon la revendication 1, **caractérisé en ce que** la sonde à effet Hall (6) est disposée sur une carte de circuit imprimé (14) s'étendant parallèlement à un axe longitudinal (12) du capteur de champ magnétique (1).

3. Capteur de champ magnétique selon la revendication 1 ou 2, **caractérisé en ce que** la tête de capteur (10) comporte un manchon de positionnement (20) qui fixe la sonde à effet Hall (6) et l'aimant permanent (8) l'un par rapport à l'autre.

4. Capteur de champ magnétique selon la revendication 3, **caractérisé en ce que** la sonde à effet Hall (6) est disposée sur une carte de circuit imprimé (14) et **en ce que** le manchon de positionnement (20) positionne la sonde à effet Hall (6) et l'aimant permanent (8) sur la carte de circuit imprimé (14).

5. Capteur de champ magnétique selon la revendication 3 ou 4, **caractérisé en ce que** le manchon de positionnement (20) est réalisé sous la forme d'un panier.

6. Capteur de champ magnétique selon l'une des revendications 3 à 5, **caractérisé en ce que** le manchon de positionnement (20) comporte sur sa face extérieure un élément d'engagement d'outil (68).

7. Capteur de champ magnétique selon l'une des revendications 3 à 6, **caractérisé en ce que** le manchon de positionnement (20) possède une forme extérieure cylindrique et **en ce que** le manchon fileté (16) possède une forme cylindrique intérieure correspondant à la forme extérieure du manchon de positionnement (20), dans lequel la forme extérieure du manchon de positionnement (20) est plus petite que la forme intérieure du manchon fileté (16).

8. Capteur de champ magnétique selon la revendication 7, **caractérisé en ce que** le manchon de positionnement (20) possède une forme extérieure cylindrique et **en ce que** le manchon fileté (16) possède une forme intérieure cylindrique, dans lequel le plus grand diamètre extérieur (70) de la forme extérieure du manchon de positionnement (20) est inférieur au plus petit diamètre intérieur (72) de la forme intérieure du manchon fileté (16).

9. Capteur de champ magnétique selon l'une des revendications 3 à 8, **caractérisé en ce que** le manchon de positionnement (20) et le manchon fileté (16) forment un raccord.

10. Capteur de champ magnétique selon l'une des revendications précédentes, **caractérisé en ce que** le manchon fileté (16) présente une forme cylindrique intérieure ayant une rainure circonférentielle intérieure (56).

11. Capteur de champ magnétique selon l'une des revendications précédentes, **caractérisé en ce que** le manchon fileté (16) comporte une bague d'étanchéité axiale (54) du capteur de champ magnétique (1).

12. Capteur de champ magnétique selon l'une des revendications précédentes, **caractérisé en ce que** le manchon fileté (16) comporte le filetage extérieur (2) dans une première zone d'extrémité de manchon du manchon fileté (16) et **en ce qu'**il présente, dans une seconde zone d'extrémité de manchon du manchon fileté (16) qui est tournée en sens opposé à la première zone d'extrémité de manchon, une structure dentée (52) encapsulée dans le composant en matière plastique moulé par injection.

13. Capteur de champ magnétique selon les revendications 11 et 12, **caractérisé en ce que** la bague d'étanchéité axiale (54) du capteur de champ magnétique (1) est disposée dans la direction axiale du manchon fileté (16) entre le filetage extérieur (2) et la structure dentée (52) du manchon fileté (16).

14. Capteur de champ magnétique selon l'une des revendications précédentes, **caractérisé en ce qu'**une première zone d'extrémité de manchon du manchon fileté (16) comportant le filetage extérieur (2) est tournée vers la tête de capteur (10).

15. Capteur de champ magnétique selon l'une des revendications précédentes, **caractérisé en ce qu'**un socle de connecteur (22) en contact électrique avec une carte de circuit imprimé (14) est disposé à une seconde extrémité du capteur de champ magnétique (1), qui est opposée à la tête de capteur (10) disposée à une première extrémité du capteur de champ magnétique (1).

16. Capteur de champ magnétique selon l'une des revendications précédentes, **caractérisé en ce qu'**une carte de circuit imprimé (14) s'étendant parallèlement à l'axe longitudinal du capteur (12) du capteur de champ magnétique (1) présente un rétrécissement (40, 42) et **en ce que** le manchon fileté (16) est disposé dans la zone du rétrécissement (40, 42) de la carte de circuit imprimé (14) de manière à ce que la carte de circuit imprimé (14) soit espacée du manchon fileté (16).
